# EUROPÄISCHE PATENTSCHRIFT

(11) **EP 3 550 656 B1**
(45) Veröffentlichungstag und Bekanntmachung des Hinweises auf die Patenterteilung: **14.09.2022**
(21) Anmeldenummer: 18165727.1
(22) Anmeldetag: 04.04.2018
(51) Int. Cl.: H01M 10/48, H01M 10/0525, H01M 10/0587, H01M 50/449, H01M 50/469

(54) **SEKUNDÄRES ENERGIESPEICHERELEMENT MIT EINER REFERENZELEKTRODE**
SECONDARY ENERGY STORAGE ELEMENT WITH A REFERENCE ELECTRODE
ÉLÉMENT DE STOCKAGE D'ÉNERGIE SECONDAIRE DOTÉ D'UNE ÉLECTRODE DE RÉFÉRENCE

(43) Veröffentlichungstag der Anmeldung: 09.10.2019
(73) Patentinhaber: VARTA Microbattery GmbH, 73479 Ellwangen Jagst (DE)
(72) Erfinder: Chumak, Ihor, 73479 Ellwangen (DE); Ensling, David, 73479 Ellwangen (DE); Scholz, Stefanie, 73479 Ellwangen (DE); Stock, Stefan, 73492 Rainau (DE)
(74) Vertreter: Ostertag & Partner Patentanwälte mbB

(56) Entgegenhaltungen:
- DE-A1-102014 001 260
- DE-A1-102017 109 690
- US-A1- 2013 323 542

## Beschreibung

Die nachfolgend beschriebene Erfindung betrifft sekundäre Energiespeicherelemente mit einer Referenzelektrode.

Zur Speicherung elektrischer Energie geeignete Elemente (kurz: Energiespeicherelemente) umfassen stets eine positive Elektrode, eine negative Elektrode und einen Separator, der die positive und die negative Elektrode voneinander trennt. Die Elektroden und der Separator sind meist mit einem Elektrolyten getränkt. In der Regel umschließt ein flüssigkeitsdicht verschlossenes Gehäuse die Elektroden, den Separator und den Elektrolyten.

In solchen Energiespeicherelementen findet eine elektrochemische, energieliefernde Reaktion statt, welche sich aus zwei elektrisch miteinander gekoppelten aber räumlich voneinander getrennten Teilreaktionen zusammensetzt. Eine bei vergleichsweise niedrigerem Redoxpotential stattfindende Teilreaktion läuft an der negativen Elektrode ab, eine bei vergleichsweise höherem Redoxpotential an der positiven Elektrode. Bei der Entladung werden an der negativen Elektrode durch einen Oxidationsprozess Elektronen freigesetzt, resultierend in einem Elektronenstrom über einen äußeren Verbraucher zur positiven Elektrode, von der eine entsprechende Menge an Elektronen aufgenommen wird. An der positiven Elektrode findet also ein Reduktionsprozess statt. Zeitgleich kommt es zum Zwecke des Ladungsausgleichs zu einem der Elektrodenreaktion entsprechenden lonenstrom innerhalb der Zelle. Dieser lonenstrom wird durch einen Ionen leitenden Elektrolyten gewährleistet.

In sekundären (wiederaufladbaren) Zellen ist diese Entladereaktion reversibel, es besteht also die Möglichkeit, die bei der Entladung erfolgte Umwandlung chemischer Energie in elektrische umzukehren. Werden im Zusammenhang mit sekundären Zellen die Begriffe "Anode" und "Kathode" benutzt, benennt man die Elektroden in der Regel entsprechend ihrer Entladefunktion. Die negative Elektrodein solchen Zellen ist also die Anode, die positive Elektrode die Kathode.

Sehr verbreitete Beispiele für sekundäre Energiespeicherelemente sind Nickel/Metallhydrid-Zellen und Lithium-Ionen-Zellen.

Insbesondere in sekundären Energiespeicherelementen sind die Elektroden und der Separator häufig als Schichten ausgebildet. In der Regel sind diese Schichten zu einem Schichtverbund miteinander verbunden, beispielsweise durch Verklebung oder durch Lamination. Solch ein Schichtverbund liegt in vielen Fällen in Form eines Wickelverbundkörpers, insbesondere eines spiralförmigen Wickels, vor. Es ist aber auch möglich, mehrere solcher Schichtverbünde zu einem Stapel zu verarbeiten.

Um den aktuellen Energiegehalt eines sekundären Energiespeicherelements ermitteln zu können, wird oftmals das Elektrodenpotential seiner Elektroden bestimmt. Das Elektrodenpotential gibt an, welche elektrische Spannung eine Elektrode liefern kann. Das Elektrodenpotential einer einzelnen Elektrode lässt sich elektrochemisch nicht bestimmen, da zur Potentialmessung stets eine zweite Elektrode benötigt wird, an der sich ebenfalls ein Elektrodenpotential ausbildet. Zu diesem Zweck kann eine Referenzelektrode verwendet werden. Das Elektrodenpotential ist dann die Spannung der Elektrode, die gegenüber der Referenzelektrode gemessen wird.

Aus dem Stand der Technik sind sekundäre Energiespeicherelemente auf Lithium-Ionen-Basis bekannt, die eine Referenzelektrode in Form metallischen Lithiums aufweisen. Alternativ kann bei Energiespeicherelementen auf Lithium-Ionen-Basis auch eine Lithiumtitanat-Referenz (sogenannte LTO-Referenz) zum Einsatz kommen. Meist werden solche Referenzelektroden in einem Gehäuse neben einem Stapel oder Wickel aus dem genannten Schichtverbund angeordnet. Ein bei einer derartigen Positionierung der Referenzelektrode gemessenes Elektrodenpotential weicht unter dynamischen Bedingungen jedoch oft deutlich von den eigentlichen Potentialverhältnissen innerhalb eines Schichtverbunds ab. Mittels derart positionierten Referenzelektroden lässt sich lediglich das Gleichgewichtspotential zuverlässig bestimmen.

Ein verbessertes Konzept zur Potentialbestimmung mittels einer Referenzelektrode ist aus der WO 2012/049201 A1 bekannt. Hier wird eine mehrschichtig aufgebaute LTO-Referenz in einen Schichtverbund aus Elektroden und Separatoren integriert, indem die Kathode mit einer Aussparung versehen wird, in die die LTO-Referenz eingefügt wird, oder indem die Referenz zwischen zwei Lagen eines mehrschichtigen Separators eingefügt wird. Damit sind auch Messungen im Elektrodenverbund möglich. Allerdings verschiebt sich in dem Bereich des Schichtverbunds, in dem die Referenz angeordnet ist, die Balance zwischen Anode und Kathode. Darüber hinaus müssen aufwendige Maßnahmen getroffen werden, um die Referenz innerhalb der Aussparung gegen einen direkten Kontakt mit der Kathode zu isolieren. Weiterhin kann die zwischen zwei Lagen eines Separators eingefügte Referenz die Ionenströme zwischen den Elektroden stören.

Die DE 10 2014 001260 A1 offenbart in Fig. 1 eine Lithiumbatterie, deren Separator eine Referenzelektrode umfasst. Die Referenzelektrode ist in eine Folie des Separators integriert oder zwischen den Lagen eines mehrlagigen Separators angeordnet. Die Referenzelektrode kann über ein Druckverfahren mit entsprechend geringer Dicke gebildet werden.

Die DE 10 2017 109690 A1 befasst sich mit der Frage, wie Artefakte, die aufgrund des Vorhandenseins einer Referenzelektrode in einer Lithiumbatterie auftreten, minimiert oder beseitigt werden können. Die Referenzelektrode wird als ein leitender Draht mit einer Widerstandsbeschichtung auf dessen Oberfläche beschrieben. Die Referenzelektrode kann dabei innerhalb eines Separators zwischen einer Gegen- und einer Arbeitselektrode angeordnet sein.

Der vorliegenden Erfindung lag die Aufgabe zugrunde, ein gegenüber dem Stand der Technik verbessertes sekundäres Energiespeicherelement mit einer Referenzelektrode bereitzustellen.

Zur Lösung dieser Aufgabe schlägt die Erfindung das sekundäre Energiespeicherelement mit einer Referenzelektrode mit den Merkmalen des Anspruch 1 vor. Weiterbildungen der Erfindung sind Gegenstand von Unteransprüchen.

Das erfindungsgemäße sekundäre Energiespeicherelement weist die folgende Merkmalskombination auf:
a: Es umfasst einen Schichtverbund mit einer Elektrodenschicht mit einem positiven Elektrodenmaterial (positive Elektrodenschicht) und einer Elektrodenschicht mit einem negativen Elektrodenmaterial (negative Elektrodenschicht) und einer dazwischen angeordneten, Separatorschicht,
b: die Separatorschicht umfasst mindestens eine Lage aus einem mikroporösen Material mit elektrisch isolierenden Eigenschaften,
c: es umfasst eine Referenzelektrode,
d: es umfasst einen Elektrolyten, mit dem der Schichtverbund getränkt ist und über den die Separatorschicht, die Elektrodenschichten und die Referenzelektrode in Kontakt stehen,
e: es umfasst ein Gehäuse, das den Schichtverbund, die Referenzelektrode und den Elektrolyten umschließt, und
f: das Gehäuse weist drei elektrisch voneinander isolierte, von außerhalb des Gehäuses abgreifbare Pole, von denen der erste mit der positiven Elektrodenschicht, der zweite mit der negativen Elektrodenschicht und der dritte mit der Referenzelektrode elektrisch verbunden ist, auf.

Gegenüber dem Stand der Technik zeichnet sich das erfindungsgemäße sekundäre Energiespeicherelement durch die folgenden zusätzlichen Merkmale aus:
g: innerhalb des Schichtverbunds schließen die positive und die negative Elektrodenschicht zwischen sich einen Überlappungsbereich ein, und
h. Die Referenzelektrode oder ein Bestandteil der Referenzelektrode ist zwischen der mindestens einen Lage der Separatorschicht und einer der Elektrodenschichten positioniert und von dieser Elektrodenschicht mittels eines Isoliermittels elektrisch isoliert, und
i: bei der Referenzelektrode oder dem dort positionierten Bestandteil der Referenzelektrode handelt es sich um mindestens ein Metallfilament oder eine bahnförmige metallische Beschichtung auf einer Oberfläche der mindestens einen Lage der Separatorschicht oder einer Oberfläche des Isoliermittels und
j. innerhalb des Überlappungsbereichs ist das mindestens eine Metallfilament oder die bahnförmige metallische Beschichtung (24) auf der Oberfläche einer Lage der Separatorschicht oder einer Oberfläche des Isoliermittels (20) angeordnet, und
k. das mindestens eine Metallfilament oder die bahnförmige metallische Beschichtung bedeckt auf dieser Oberfläche eine Fläche von maximal 5 % der Fläche, besonders bevorzugt von maximal 1 % der Fläche, über die sich der Überlappungsbereich erstreckt.

Der Überlappungsbereich lässt sich als der Bereich definieren, in dem eine Gerade senkrecht zu den Elektrodenschichten beide Elektrodenschichten schneidet. Durch die geringe Flächenbedeckung des Metallfilaments oder der Beschichtung ist gewährleistet, dass die Funktionsfähigkeit des Schichtverbunds durch die Anwesenheit des Filaments oder der Beschichtung nicht beeinträchtigt wird.

In einem erfindungsgemäßen sekundären Energiespeicherelement ist die Referenzelektrode oder ein Bestandteil der Referenzelektrode also in den Schichtverbund integriert, allerdings nicht in der Ebene der positiven Elektrode, wie es in der WO 2012/049201 A1 vorgeschlagen wird, sondern eben zwischen einer der Elektrodenschichten und der Separatorschicht oder in der Separatorschicht. Die Referenzelektrode beeinflusst daher auch nicht die Elektrodenbalancierung. Darüber hinaus werden im Gegensatz zur WO 2012/049201 A1 innerhalb des Schichtverbundes auch lediglich ein Metallfilament oder eine bahnförmige metallische Beschichtung angeordnet und nicht eine mehrschichtig aufgebaute LTO-Referenz.

Im Vergleich zu Energiespeicherelementen mit außerhalb des Schichtverbundes angeordneten Referenzelektroden ermöglicht die erfindungsgemäße Ausgestaltung eine exakte Erfassung von Elektrodeneinzelpotentialen, auch unter dynamischen Bedingungen. Potentialverhältnisse können innerhalb des Schichtverbunds abgegriffen werden. Die hierbei gewonnenen Messdaten können beispielsweise genutzt werden, um Aussagen über den aktuellen Ladezustand, die Zellalterung sowie zu Sicherheitsaspekten wie beispielsweise Lithium-Plating zu treffen.

Der Schichtverbund umfasst die Schichten in der Sequenz positive Elektrodenschicht / Separatorschicht / negative Elektrodenschicht. Bevorzugt ist eine der Elektroden zwischen zwei Separatorschichten angeordnet, so dass der Schichtverbund die Sequenz positive Elektrodenschicht / Separatorschicht / negative Elektrodenschicht / Separatorschicht oder die Sequenz negative Elektrodenschicht / Separatorschicht / positive Elektrodenschicht / Separatorschicht aufweist.

Die Elektroden des Energiespeicherelements können auf ganz unterschiedlichen Materialien basieren. Die Erfindung ist auf grundsätzlich jedes elektrochemische System anwendbar. Allerdings ist es bevorzugt, wenn es sich bei dem Energiespeicherelement um ein Lithium-Ionen-Speicherelement, also um ein Energiespeicherelement mit Elektroden, die im Betrieb Lithiumionen interkalieren und deinterkalieren, handelt.

Die Elektrodenschichten des erfindungsgemäßen Energiespeicherelements umfassen üblicherweise jeweils einen metallischen Stromkollektor sowie elektrochemisch aktive Komponenten (oft auch als Elektrodenaktivmaterial bezeichnet) und elektrochemisch inaktive Komponenten.

Die Stromkollektoren dienen dazu, die elektrochemisch aktiven Komponenten möglichst großflächig elektrisch zu kontaktieren. Sie bestehen üblicherweise aus flächigen Metallsubstraten, beispielsweise aus Metallfolien oder aus einem Metallschaum oder aus einem metallisierten Vlies. Diese flächigen Metallsubstrate sind in der Regel beidseitig mit den Elektrodenaktivmaterialien beschichtet. Eine Elektrodenschicht umfasst somit bevorzugt zwei Lagen mit den Elektrodenaktivmaterialien und dazwischen einen Stromkollektor.

Als Elektrodenaktivmaterialien kommen, wenn es sich bei dem Energiespeicherelement um ein Lithium-lonen-Speicherelement handelt, sämtliche Materialien in Frage, die Lithium-Ionen aufnehmen und wieder abgeben können. Stand der Technik sind diesbezüglich für die negative Elektrode beispielsweise Materialien auf Kohlenstoffbasis wie graphitischer Kohlenstoff oder zur reversiblen Aufnahme von Lithium befähigten nicht graphitische Kohlenstoffmaterialien. Für die positive Elektrode sekundärer Lithiumionen-Systeme kommen beispielsweise Lithiummetalloxid-Verbindungen und Lithiummetallphosphat-Verbindungen wie LiCoO₂ und LiFePo4 in Frage.

Als elektrochemisch inaktive Komponenten sind an erster Stelle Elektrodenbinder und Leitmittel zu nennen. Elektrodenbinder gewährleisten die mechanische Stabilität der Elektroden und sorgen für die Kontaktierung der Partikel aus elektrochemisch aktivem Material untereinander sowie zum Stromkollektor. Leitmittel wie Ruß dienen dazu, elektrische Leitfähigkeit der Elektroden zu ermöglichen. Geeignete Elektrodenbinder und Leitmittel für die unterschiedlichen elektrochemischen Systeme in Energiespeicherelementen sind dem Fachmann bekannt.

Als Separatoren kommen für die genannten Schichtverbünde insbesondere poröse Kunststoffseparatoren, beispielsweise poröse Kunststoffmembranen in Frage, beispielweise aus einem Polyolefin oder aus einem Polyetherketon. Auch Vliese und Gewebe aus diesen Materialien können zum Einsatz kommen.

Die Elektrodenschichten weisen - unabhängig davon, ob der Schichtverbund als Wickelverbundkörper, insbesondere als spiralförmiger Wickel, ausgebildet oder Teil eines Stapels ist, bevorzugt eine Dicke im Bereich von 20 µm bis 800 µm auf. Als Separatorschicht werden bevorzugt Separatoren mit einer Dicke im Bereich von 5 µm bis 200 µm eingesetzt.

Wenn es sich bei dem Energiespeicherelement um ein Lithium-Ionen-Speicherelement handelt, kommt bevorzugt ein organischer Elektrolyt, insbesondere auf Basis organischer Carbonate zum Einsatz. Bei NiMH-Systemen kommen wässrige, alkalische Elektrolyte zum Einsatz.

In einer ersten besonders bevorzugten Variante A zeichnet sich das sekundäre Energiespeicherelement durch mindestens eines, bevorzugt durch alle der folgenden zusätzlichen Merkmale aus:
a: Die Separatorschicht ist mehrlagig ausgebildet und umfasst eine erste Lage aus dem mikroporösen Material mit den elektrisch isolierenden Eigenschaften und eine zweite Lage aus dem mikroporösen Material mit den elektrisch isolierenden Eigenschaften.
b: Bei dem Isoliermittel handelt es sich um die zweite Lage.
c: Die Referenzelektrode oder der Bestandteil der Referenzelektrode ist zwischen der ersten und der zweiten Lage angeordnet.

Bei dem Isoliermittel handelt es sich hier also um eine Lage der Separatorschicht. Diese umfasst entsprechend mindestens zwei Lagen aus dem mikroporösen Material. In Variante A ist die Referenzelektrode oder der Bestandteil der Referenzelektrode also innerhalb der Separatorschicht angeordnet. Dabei ist es bevorzugt, wenn es sich bei den Lagen jeweils um poröse Kunststoffmembranen oder Vliese oder Gewebe aus Kunststofffasern handelt. Bevorzugt bestehen die erste und die zweite Lage aus einem identischen Material. Die Lagen können beispielsweise durch Verklebung oder durch Lamination miteinander verbunden sein.

Es ist grundsätzlich möglich, dass zwischen der ersten und der zweiten Lage der Separatorschicht eine oder mehrere weitere Lagen (Zwischenlagen) angeordnet sind. Diese können aus einem anderen Material bestehen, als die erste und die zweite Lage, beispielsweise einem niedriger schmelzenden Kunststoff, um im Falle einer unplanmäßigen Erhitzung durch Schmelzen einen Shutdown der Poren der Separatorschicht bewirken zu können. In diesem Fall ist die Referenzelektrode entweder zwischen der ersten Lage und einer Zwischenlage oder zwischen der zweiten Lage und einer Zwischenlage oder zwischen zwei Zwischenlagen angeordnet.

Eine derartige Anordnung ermöglicht grundsätzlich nicht nur die exakte Erfassung von Elektrodeneinzelpotentialen, beispielsweise wird auch die Detektion von in die Separatorschicht eindringenden Dendriten ermöglicht. Zur Detektion derartiger Dendriten werden beispielsweise die Potentialdifferenz zwischen der positiven und der negativen Elektrodenschicht und die Potentialdifferenz zwischen der negativen Elektrodenschicht und einer innerhalb der Separatorschicht angeordneten Referenzelektrode überwacht. Fällt die Spannung zwischen der negativen Elektrodenschicht und der Referenzelektrode auf Null ab, ist dies meist auf einen Kurzschluss zwischen der Referenzelektrode und der negativen Elektrode in Folge eines Eindringens von Dendriten in die Separatorschicht zurückzuführen. Das so überwachte Energiespeicherelement kann dann abgeschaltet werden, bevor es zu einem Kurzschluss zwischen den Elektrodenschichten kommt.

In einer zweiten besonders bevorzugten Variante B zeichnet sich das sekundäre Energiespeicherelement durch mindestens eines, bevorzugt durch alle der folgenden zusätzlichen Merkmale aus:
a: Die Separatorschicht ist einlagig oder mehrlagig ausgebildet.
b: Bei dem Isoliermittel handelt es sich um eine Beschichtung auf einer Außenseite der Separatorschicht oder auf einer Außenseite einer der Elektrodenschichten, wobei die Referenzelektrode oder der Bestandteil der Referenzelektrode zwischen der Außenseite der Separatorschicht und der Beschichtung angeordnet ist.

In dieser Variante B weist das sekundäre Energiespeicherelement also eine Referenzelektrode auf, die nicht in eine mehrlagige Separatorschicht integriert ist. Stattdessen ist die Referenzelektrode oder der Bestandteil der Referenzelektrode in unmittelbarem Kontakt mit einer der Außenseiten der Separatorschicht positioniert. In diesem Fall ist eine Isolierung gegenüber der angrenzenden Elektrodenschicht erforderlich, was durch die Beschichtung gewährleistet wird. Diese Beschichtung kann sowohl unmittelbar auf die angrenzende Elektrodenschicht als auch auf die Separatorschicht aufgebracht werden. Im letzteren Fall wird bevorzugt zuerst die Referenzelektrode oder der Bestandteil der Referenzelektrode auf die Außenseite der Separatorschicht aufgebracht und dann mit der Beschichtung abgedeckt.

Ungeachtet dessen kann die Separatorschicht auch bei dieser Variante einen mehrlagigen Aufbau aufweisen. Sie ist dann bevorzugt ausgebildet wie bei der Beschreibung der Variante A definiert.

Das mindestens eine Metallfilament oder die bahnförmige metallische Beschichtung deckt in einigen bevorzugten Ausführungsformen den gesamten Kontaktbereich zwischen der Separatorschicht und der Elektrodenschicht, zwischen denen sich die Referenzelektrode oder der Bestandteil der Referenzelektrode befindet, gleichmäßig ab. Alternativ kann die Beschichtung aber auch auf einen lokalen Kontaktbereich um eine lokale Referenzelektrode beschränkt sein.

Die Beschichtung ist bevorzugt aus einem mikroporösen Material mit elektrisch isolierenden Eigenschaften, beispielsweise aus Keramikpartikeln oder Kunststoffpartikeln gebildet.

In einer dritten besonders bevorzugten Variante C zeichnet sich das sekundäre Energiespeicherelement durch mindestens eines, bevorzugt durch alle der folgenden zusätzlichen Merkmale aus:
a: Die Separatorschicht ist einlagig oder mehrlagig ausgebildet.
b: Bei dem Isoliermittel handelt es sich um eine Folie, die zwischen der Referenzelektrode oder dem Bestandteil der Referenzelektrode und der Elektrodenschicht angeordnet ist.

Auch in dieser dritten bevorzugten Variante weist das Energiespeicherelement eine Referenzelektrode auf, die nicht in der Separatorschicht integriert ist. Die Referenzelektrode oder der Bestandteil der Referenzelektrode steht hier vielmehr in bevorzugt unmittelbarem Kontakt mit einer der Außenseiten der Separatorschicht und ist über die Folie gegenüber der an diese Außenseite angrenzenden Elektrodenschicht isoliert. Bevorzugt ist die Referenzelektrode oder der Bestandteil der Referenzelektrode als Beschichtung auf die Folie, insbesondere eine der angrenzenden Elektrodenschicht abgewandten Flachseite der Folie, aufgebracht. Im letzteren Fall wird bevorzugt zuerst die Referenzelektrode oder der Bestandteil der Referenzelektrode auf die Außenseite der Separatorschicht aufgebracht und dann mit der Beschichtung abgedeckt.

Die Separatorschicht kann auch bei dieser Variante einen mehrlagigen Aufbau aufweisen. Sie ist dann bevorzugt ausgebildet wie bei der Beschreibung der Variante A definiert.

Diese Ausführungsform ist insbesondere dann interessant, wenn die Referenzelektrode oder der Bestandteil der Referenzelektrode das Filament ist oder nur als dünne Bahn vorliegt, so dass das Isoliermittel nur die Form eines dünnen Streifens aufweisen muss, um die Referenzelektrode oder den Bestandteil der Referenzelektrode abdecken zu können. Besonders bevorzugt ist die Folie streifenförmig ausgebildet.

Die Folie besteht bevorzugt aus einem elektrisch isolierenden Kunststoffmaterial, insbesondere einem mikroporösem Kunststoffmaterial mit elektrisch isolierenden Eigenschaften.

In einer vierten besonders bevorzugten Variante D zeichnet sich das sekundäre Energiespeicherelement durch mindestens eines, bevorzugt durch alle der folgenden zusätzlichen Merkmale aus:
a: Die Separatorschicht ist einlagig oder mehrlagig ausgebildet.
b: Bei dem Isoliermittel handelt es sich um eine mikroporöse Beschichtung mit elektrisch isolierenden Eigenschaften auf einer Außenseite der Referenzelektrode oder auf einer Außenseite des Bestandteils der Referenzelektrode.

Auch in dieser Variante D umfasst das sekundäre Energiespeicherelement eine Referenzelektrode, die nicht in den Separator integriert ist. Die Referenzelektrode kann beispielsweise ein dünnes Metallfilament umfassen, welches eine elektrisch isolierende jedoch ionendurchlässige Beschichtung aufweist. Das Isoliermittel ist dann beispielsweise ein dünner elektrisch isolierender und mikroporöser Kunststofffilm auf der Oberfläche des Metallfilaments. Eine Folie ist dann als Isoliermittel nicht erforderlich.

Die Separatorschicht kann auch bei dieser Variante einen mehrlagigen Aufbau aufweisen. Sie ist dann bevorzugt ausgebildet wie bei der Beschreibung der Variante A definiert.

Unter möglichen Weiterbildungen des erfindungsgemäßen Energiespeicherelements, die alle vier der beschriebenen bevorzugten Varianten A-D betreffen können, gibt es zwei besonders bevorzugte Ausführungsformen.

In der ersten dieser zwei Ausführungsformen weist das Energiespeicherelement das folgende zusätzliche Merkmal auf:
a: Das Metallfilament oder die bahnförmige metallische Beschichtung besteht aus einem mit Lithium legierbaren Metall oder einer mit Lithium legierbaren Metalllegierung, das oder die im Betrieb des Energiespeicherelements unter üblichen Betriebsbedingungen (Betriebstemperatur bis 80 °C) Lithium-Ionen reversibel aufnimmt und wieder abgibt.

In dieser Ausführungsform sind das Metallfilament oder die bahnförmige metallische Beschichtung selbst die Referenzelektrode und nicht nur ein Teil derselben. Selbstverständlich ist das Speicherelement in dieser Ausführungsform bevorzugt ein Lithium-Ionen-Speicherelement.

Bei dem Metall, das Lithium-Ionen im Betrieb aufnimmt und wieder abgibt, handelt es sich besonders bevorzugt um ein Metall aus der Gruppe mit Gold, Silber, Aluminium, Antimon, Zinn und Silizium. Alle diese Metalle sowie weiterhin auch Titan, Nickel und Edelstähle, insbesondere hochedle Edelstähle, können auch in prälithiierter Form eingesetzt werden, sie weisen dann bevorzugt bereits vor der ersten Inbetriebnahme einen Anteil von Lithium > 1 Gew.-%, bevorzugt > 2,5 Gew.-%, insbesondere > 5 Gew.-%, besonders bevorzugt > 10 Gew.-%, auf. Selbst Kupfer, das unter den üblichen Betriebsbedingungen im Betrieb praktisch kein Lithium aufnimmt, lässt sich in prälithiierter Form verwenden. Es weist das Lithium dann bevorzugt in einem Anteil > 10 Gew.-% auf.

In der zweiten dieser zwei Ausführungsformen weist das Energiespeicherelement die folgenden zusätzlichen Merkmale auf:
a: Die Referenzelektrode umfasst als ersten Bestandteil eine Elektrode auf Basis einer Verbindung, die Lithium-Ionen reversibel aufnehmen und wieder abgeben kann.
b: Als zweiten Bestandteil umfasst die Referenzelektrode das mindestens eine Metallfilament oder die bahnförmige metallische Beschichtung.
c: Das Metallfilament oder die bahnförmige metallische Beschichtung besteht aus einem Metall oder einer Metalllegierung, das oder die im Betrieb des Speicherelements unter üblichen Betriebsbedingungen (Betriebstemperatur bis 80 °C) weder mit Lithium legiert noch Lithium-Ionen reversibel aufnimmt und wieder abgibt.
d: Ausschließlich der zweite Bestandteil der Referenzelektrode ist zwischen der mindestens einen Lage aus dem mikroporösen Material und einer der Elektrodenschichten positioniert.
e: Der erste und der zweite Bestandteil der Referenzelektrode sind elektrisch miteinander verbunden.

Hier sind das Metallfilament oder die bahnförmige metallische Beschichtung also nicht selbst die Referenzelektrode sondern lediglich ein Teil derselben. Sie fungieren lediglich als Sonde, die elektrisch mit der eigentlichen Referenz, dem ersten Bestandteil der Referenzelektrode, verbunden ist. Die Sonde ist dann also in den Schichtverbund integriert, nicht aber die Referenz. Selbstverständlich ist das Speicherelement auch in dieser Ausführungsform bevorzugt ein Lithium-Ionen-Speicherelement.

Besonders bevorzugt ist der erste Bestandteil der Referenzelektrode innerhalb des Gehäuses aber außerhalb des Schichtverbunds angeordnet. Bevorzugt steht er über den Elektrolyten mit den Elektrodenschichten und der Separatorschicht in Kontakt.

Der zweite Bestandteil der Referenzelektrode, die Sonde, besteht bevorzugt aus einem Metall, welches im Betrieb des Energiespeicherelements unter üblichen Betriebsbedingungen (Betriebstemperatur bis 80 °C) keine Lithium-Ionen aufnimmt und wieder abgibt. Besonders bevorzugt handelt es sich um ein Metall aus der Gruppe mit Titan, Nickel, Edelstahl, insbesondere hochedler Edelstahl, und Kupfer.

Bevorzugt umfasst der erste Bestandteil der Referenzelektrode eine Lithiummetalloxid-Verbindung oder einer Lithium-Eisen-Phosphat-Verbindung oder Lithium-Nickel-Mangan-Cobaltoxid-Verbindung oder einer Lithium-Titanat-Verbindung oder einer Lithium-Nickel-Cobalt-Aluminiumoxid-Verbindung.

Es ist besonders bevorzugt, dass das sekundäre Energiespeicherelement eines der folgenden zusätzlichen Merkmale aufweist:
a: Die zwischen der Separatorschicht und der einen der Elektrodenschichten positionierte Referenzelektrode oder der dort positionierte Bestandteil der Referenzelektrode, insbesondere die Sonde, liegt in Form einer Beschichtung vor, die über eine physikalische oder chemische Gasphasenabscheidung gebildet wurde.
b: Die zwischen der Separatorschicht und der einen der Elektrodenschichten positionierte Referenzelektrode oder der dort positionierte Bestandteil der Referenzelektrode, insbesondere die Sonde, liegt in Form einer Beschichtung vor, die über ein Druckverfahren gebildet wurde.

Die Bildung der Referenzelektrode oder der Sonde mittels Gasphasenabscheidung oder Druck kann beispielsweise auf einer Oberfläche der Separatorschicht oder einer der Separatorlagen oder auf dem Isoliermittel, beispielsweise auf der Folie gemäß obiger Variante D, oder auf der isolierenden Beschichtung gemäß obiger Variante C erfolgen.

Es ist besonders bevorzugt, dass das sekundäre Energiespeicherelement mindestens eines der folgenden zusätzlichen Merkmale aufweist:
a: Die bahnförmige metallische Beschichtung ist oder umfasst eine Bahn mit einer Breite im Bereich von 0,1 mm bis 5 mm.
b: Die bahnförmige metallische Beschichtung umfasst mindestens eine Bahn mit einer Dicke im Bereich von 5 nm bis 500 nm.
c: Der Durchmesser des mindestens einen Filaments liegt im Bereich von 10 µm bis 100 µm.
d: Das mindestens eine Metallfilament oder die Bahnen der bahnförmigen metallischen Beschichtung bilden eine Leiterstruktur aus.

Die bahnförmige metallische Beschichtung ist oder umfasst bevorzugt eine Bahn mit einer im Wesentlichen gleichmäßigen Breite, insbesondere innerhalb des genannten Zahlenbereichs. Besonders bevorzugt weist diese Bahn sowohl eine Breite als auch eine Dicke innerhalb der genannten Zahlenbereiche auf.

Das Filament liegt bevorzugt über seine gesamte Länge mit konstantem Durchmesser vor. Es kann in einer netz- oder gitterartigen Anordnung vorliegen

Es ist besonders bevorzugt, dass das sekundäre Energiespeicherelement eines der folgenden zusätzlichen Merkmale aufweist:
a: das Gehäuse ist ein metallisches Gehäuse mit zwei Poldurchführungen.
b: das Gehäuse ist ein metallisches oder nichtmetallisches Gehäuse mit drei Poldurchführungen.

Damit der Elektronenstrom über einen äußeren Verbraucher gewährleistet ist, muss das Gehäuse des sekundären Energiespeicherelements mindestens zwei elektrische Anschlussstellen, einen Plus- und einen Minus-Pol umfassen. Eine weitere elektrische Anschlussstelle muss für die Referenzelektrode vorgesehen sein.

In einer bevorzugten Ausführungsform ist das Gehäuse derart ausgestaltet, dass eine der Anschlussstellen das elektrisch leitende, bevorzugt metallische Gehäuse selbst ist. Somit kann beispielsweise der Minus-Pol, oder aber auch jede andere elektrische Anschlussstelle, das Gehäuse sein. In dieser Ausführungsform sind lediglich zwei Poldurchführungen erforderlich.

In einer bevorzugten Ausführungsform ist das Gehäuse selber nicht leitend. In diesem Fall benötigt es drei Poldurchführungen.

Das sekundäre Energiespeicherelement gemäß der Erfindung kann in vielen gängigen Bauformen vorliegen, beispielsweise als Rundzelle, Knopfzelle, prismatische Zelle, Pouchzelle etc.. Das Gehäuse ist dann jeweils entsprechend ausgebildet.

Es ist besonders bevorzugt, dass das sekundäre Energiespeicherelement eine elektronische Schaltung zur Überwachung seiner Spannung umfasst, die über elektrische Leiter mit den Elektrodenschichten und der Referenzelektrode elektrisch verbunden ist. Die elektronische Schaltung ist bevorzugt derart ausgebildet, dass sie das Elektrodeneinzelpotenzial des sekundären Energiespeicherelements überwachen kann. In einer bevorzugten Ausführungsform kann die elektronische Schaltung die Spannung zwischen den Elektroden und der Referenzelektrode überwachen und im Falle eines Kurzschlusses das sekundäre Energiespeicherelement von einem Verbund mehrerer Energiespeicherelemente elektrisch trennen und/oder eine Fehlermeldung anzeigen oder an eine weitere elektronische Einheit weiterleiten.

In einer besonders bevorzugten Variante weist das sekundäre Energiespeicherelement die folgenden Merkmale auf:
a: Die Elektrodenschichten und die Separatorschicht liegen in Form von Bändern vor und sind zu einem bandförmigen Schichtverbund zusammengefügt.
b: Der bandförmige Schichtverbund liegt als Wickel vor und umfasst die Elektrodenschichten und die Separatorschicht in einer spiralförmig um eine Wickelachse gewickelten Anordnung.
c: Der Wickel weist zwei Stirnseiten auf, die von Längsrändern der Elektrodenschichten und der Separatorschicht gebildet werden.
d: Das Isoliermittel ist ein Streifen einer Folie aus einem mikroporösen Material mit elektrisch isolierenden Eigenschaften, der eine erste und eine zweite Flachseite aufweist.
e: Die Referenzelektrode oder der Bestandteil der Referenzelektrode ist eine bahnförmige metallische Beschichtung auf der ersten Flachseite des Folienstreifens.
f: Der Folienstreifen ist mitsamt der bahnförmigen metallischen Beschichtung in den Schichtverbunds integriert und parallel zu der Wickelachse ausgerichtet, so dass ein Ende des Folienstreifens an einer der Stirnseiten aus dem Wickel herausragt.
g: Innerhalb des Schichtverbunds steht die erste Flachseite des Folienstreifens in Kontakt mit der Separatorschicht und die zweite Flachseite in Kontakt mit einer der Elektrodenschichten.

Die bahnförmige metallische Beschichtung ist vorzugsweise an dem aus der Stirnseite des Wickels herausragenden Ende des Folienstreifens mit einem elektrischen Leiter verbunden. Wenn die Beschichtung die Referenzelektrode ist, so kann diese über den elektrischen Leiter mit einer der Elektrodenschichten und/oder der elektronischen Schaltung verbunden werden. Wenn die Beschichtung der Bestandteil der Referenzelektrode, insbesondere die erwähnte Sonde, ist, so kann dieser über den elektrischen Leiter mit der eigentlichen Referenz verbunden werden.

In einer weiteren besonders bevorzugten Variante weist das sekundäre Energiespeicherelement die folgenden Merkmale auf:
a: Die Elektrodenschichten und die Separatorschicht liegen in Form von Schichten vor und sind zu einem Schichtverbund zusammengefügt.
b: Der Schichtverbund ist Bestandteil eines Stapels aus mindestens zwei Schichtverbünden.
d: Das Isoliermittel ist ein Streifen aus einer Folie aus einem mikroporösen Material mit elektrisch isolierenden Eigenschaften, der eine erste Flachseite und eine zweite Flachseite aufweist.
e: Die Referenzelektrode oder der Bestandteil der Referenzelektrode ist eine bahnförmige metallische Beschichtung auf der ersten Flachseite des Folienstreifens.
f: Der Folienstreifen ist mitsamt der bahnförmigen metallischen Beschichtung in mindestens einen der den Stapel bildenden Schichtverbünde integriert, wobei ein Ende des Folienstreifens aus dem Stapel herausragt, so dass die bahnförmige metallische Beschichtung frei zugänglich ist.
g: Innerhalb des mindestens einen Schichtverbunds steht die erste Flachseite des Folienstreifens in Kontakt mit der Separatorschicht und die zweite Flachseite in Kontakt mit einer der Elektrodenschichten.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnungen. Hierbei zeigt schematisch:
Figur 1 ein Endstück einer bandförmigen Elektrodenschicht samt einer darauf angeordneten Streifen aus einer Folie mit einer metallischen Beschichtung, die zu einem Schichtverbund eines erfindungsgemäßen Energiespeicherelements verarbeitet werden kann (Draufsicht von oben); und
Figur 2 einen unter Verwendung der in Fig. 1 dargestellten Elektrodenschicht hergestellten Schichtverbund in Form eines Wickels (Draufsicht schräg von vorn), und
Figur 3 eine Ausführungsform eines erfindungsgemäßen sekundären Energiespeicherelements bei dem ein Schichtverbund, wie er in Fig. 1 dargestellt ist, in einem Gehäuse angeordnet ist (geschnittene Darstellung), und
Figur 4 eine weitere Ausführungsform eines erfindungsgemäßen sekundären Energiespeicherelements bei dem ein Schichtverbund, wie er in Fig. 1 dargestellt ist, in einem Gehäuse angeordnet ist (geschnittene Darstellung).

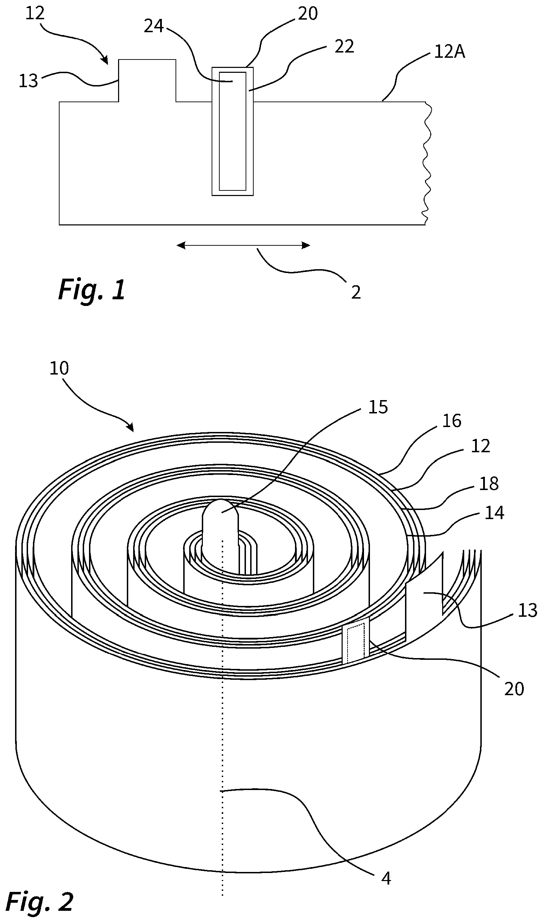

Die in Fig. 1 dargestellte Elektrodenschicht 12 ist bandförmig ausgebildet. Sie umfasst eine Ableiterfahne 13. Diese ist an einen von positivem Elektrodenaktivmaterial bedeckten Stromkollektor (nicht im Detail dargestellt) angekoppelt und dient zur elektrischen Kontaktierung der Elektrodenschicht 12. Bei dem Elektrodenaktivmaterial handelt es sich um ein Lithium interkalierendes Material.

Auf der Elektrodenschicht ist ein als Isoliermittel dienender Streifen 20 aus einer Folie aus einem mikroporösen Material mit elektrisch isolierenden Eigenschaften angeordnet. Diese weist eine erste und eine zweite Flachseite auf, wobei die erste Flachseite hier als Oberseite 22 des Streifens 20 sichtbar ist. Auf diese Oberseite 20 ist mittels einer Gasphasenabscheidung oder mittels eines Druckverfahrens eine bahnförmige metallische Beschichtung 24 mit einer Dicke von beispielsweise 100 nm aufgebracht. Der Streifen 20 ist senkrecht zur Haupterstreckungsrichtung 2 der bandförmigen Elektrodenschicht 12 angeordnet, wobei er auf der Seite der Ableiterfahne 13 über den Längsrand 12a der Elektrodenschicht 12 übersteht. In einem unter Verwendung der Elektrodenschicht 12 gefertigten Wickel steht sein überstehendes Ende daher stirnseitig aus dem Wickel heraus. Die metallische Beschichtung 24 ist mittels des Streifens 20 von der Elektrodenschicht 12 isoliert.

Ein solcher Wickel 10 ist in Fig. 2 dargestellt. Bei dem Wickel 10 handelt es sich präziser um einen Schichtverbund in Form eines Wickels, zu dessen Bildung die in Fig. 1 dargestellte bandförmige Elektrodenschicht 12 mit einer bandförmigen Elektrodenschicht entgegengesetzter Polarität 14 und zwei bandförmigen Separatorschichten 16, 18 zu einem bandförmigen Schichtverbund kombiniert und um eine Wickelachse 4 (gepunktete Linie) herum aufgewickelt wird. Die Elektrodenschicht 14 umfasst wie die Elektrodenschicht 12 ein Lithium interkalierendes Elektrodenaktivmaterial.

Die Separatorschichten 16 und 18 sind bevorzugt einlagig ausgebildet, sie umfassen jeweils eine Lage aus einem mikroporösen Kunststoffmaterial. Der Wickel 10 weist zwei Stirnseiten auf, die von Längsrändern der Elektrodenschichten 12 und 14 und den Separatorschichten 16 und 18 gebildet werden.

Aus der hier obenliegenden, sichtbaren Stirnseite tritt neben der Ableiterfahne 13 und dem bereits erwähnten überstehenden Ende des Streifens 20 eine zweite Ableiterfahne 15 aus. Letztere dient zur elektrischen Kontaktierung der Elektrodenschicht 14.

Die Beschichtung 24 ist innerhalb des Wickels zwischen der Elektrodenschicht 12 und der Elektrodenschicht 14 positioniert. Von der Elektrodenschicht 12 ist sie durch den Streifen 20 isoliert, von der Elektrodenschicht 14 durch den Separator 18, also eine Lage aus einem mikroporösen Kunststoffmaterial.

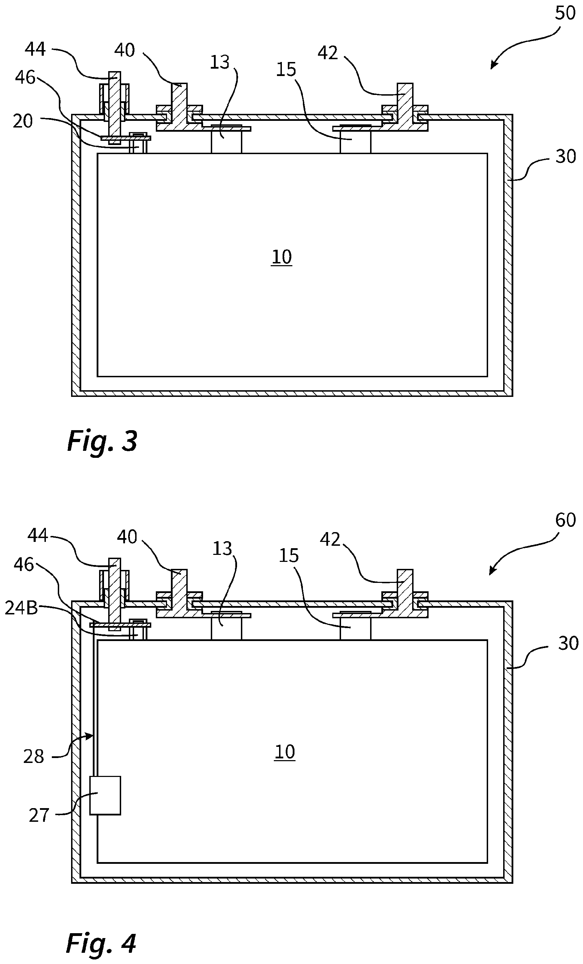

Das in Fig. 3 dargestellte Energiespeicherelement 50 umfasst eine Ausführungsform des Wickels 10, bei der die bahnförmige metallische Beschichtung aus prälithiiertem Gold besteht. Die Beschichtung bildet eine funktionsfähige Referenzelektrode 24A.

Der Wickel 10 ist von dem Gehäuse 30 umschlossen. Dieses ist mit einem Elektrolyten befüllt, mit dem auch der Wickel 10 getränkt ist. Durch das Gehäuse sind drei Pole 40, 42 und 44 geführt. Alle Pole sind gegenüber dem Gehäuse 30 elektrisch isoliert. Der Pol 42 ist elektrisch mit der Ableiterfahne 15 verbunden. Der Pol 40 ist elektrisch mit der Ableiterfahne 13 verbunden. Der Pol 44 ist elektrisch über den Anschlusskontakt 46, bei dem es sich beispielsweise um eine Klemme handeln kann, mit der Referenzelektrode 24A verbunden.

Das in Fig. 4 dargestellte Energiespeicherelement 60 umfasst eine Ausführungsform des Wickels 10, bei der die bahnförmige metallische Beschichtung aus einem Metall besteht, das keine Lithiumionen interkaliert. Die Beschichtung fungiert lediglich als Sonde 24B. Die Referenzelektrode ist in diesem Ausführungsbeispiel zweiteilig aufgebaut und umfasst neben der Sonde 24B die LTO-Referenz 27. Diese ist über den Anschlusskontakt 46 und den elektrischen Leiter 28 mit der Sonde 24B elektrisch verbunden.

Ansonsten bestehen zur Ausführungsform 50 keine Unterschiede.

## Patentansprüche

1. Sekundäres Energiespeicherelement (50; 60) mit den Merkmalen
a: es umfasst einen Schichtverbund (10) mit einer Elektrodenschicht (12) umfassend ein positives Elektrodenmaterial und einer Elektrodenschicht (14) umfassend ein negatives Elektrodenmaterial und einer dazwischen angeordneten Separatorschicht (18),
b: die Separatorschicht (18) umfasst mindestens eine Lage aus einem mikroporösen Material mit elektrisch isolierenden Eigenschaften,
c: es umfasst eine Referenzelektrode (24A; 24B, 27),
d: es umfasst einen Elektrolyten, mit dem der Schichtverbund (10) getränkt ist und über den die Separatorschicht (18), die Elektrodenschichten (12 und 14) und die Referenzelektrode (24A; 24B, 27) in Kontakt stehen,
e: es umfasst ein Gehäuse (30), das den Schichtverbund (10), die Referenzelektrode (24A; 24B, 27) und den Elektrolyten umschließt,
f: das Gehäuse (30) weist drei elektrisch voneinander isolierte, von außerhalb des Gehäuses (30) abgreifbare Pole, von denen der erste Pol (40) mit der Elektrodenschicht (12) mit dem positiven Elektrodenmaterial, der zweite Pol (42) mit der Elektrodenschicht (14) mit dem negativen Elektrodenmaterial und der dritte Pol (44) mit der Referenzelektrode (24A; 24B, 27) elektrisch verbunden ist, auf,
sowie den zusätzlichen Merkmalen
g: innerhalb des Schichtverbunds schließen die positive und die negative Elektrodenschicht zwischen sich einen Überlappungsbereich ein, und
h: die Referenzelektrode (24A) oder ein Bestandteil (24B) der Referenzelektrode (24B, 27) ist zwischen der mindestens einen Lage der Separatorschicht (18) und einer der Elektrodenschichten (12) positioniert und von dieser Elektrodenschicht (12) mittels eines Isoliermittels (20) elektrisch isoliert, und
i: bei der Referenzelektrode (24A) oder dem dort positionierten Bestandteil (24B) der Referenzelektrode (24B, 27) handelt es sich um mindestens ein Metallfilament oder eine bahnförmige metallische Beschichtung (24), das oder die innerhalb des Überlappungsbereichs auf einer Oberfläche der mindestens einen Lage der Separatorschicht oder einer Oberfläche (22) des Isoliermittels (20) angeordnet ist, und
j: das mindestens eine Metallfilament oder die bahnförmige metallische Beschichtung bedeckt auf dieser Oberfläche eine Fläche von maximal 5 % der Fläche, über die sich der Überlappungsbereich erstreckt.

2. Energiespeicherelement nach Anspruch 1 mit den folgenden zusätzlichen Merkmalen:
a: Die Separatorschicht ist mehrlagig ausgebildet und umfasst eine erste Lage aus dem mikroporösen Material mit den elektrisch isolierenden Eigenschaften und eine zweite Lage aus dem mikroporösen Material mit den elektrisch isolierenden Eigenschaften.
b: Bei dem Isoliermittel handelt es sich um die zweite Lage.
c: Die Referenzelektrode oder der Bestandteil der Referenzelektrode ist zwischen der ersten und derzweiten Lage angeordnet.

3. Energiespeicherelement nach Anspruch 1 mit den folgenden zusätzlichen Merkmalen:
a: Die Separatorschicht ist einlagig oder mehrlagig ausgebildet.
b: Bei dem Isoliermittel handelt es sich um eine Beschichtung auf einer Außenseite der Separatorschicht oder einer Außenseite einer der Elektrodenschichten, wobei die Referenzelektrode oder der Bestandteil der Referenzelektrode zwischen der Außenseite der Separatorschicht und der Beschichtung angeordnet ist.

4. Energiespeicherelement (50; 60) nach Anspruch 1 mit den folgenden zusätzlichen Merkmalen:
a: Die Separatorschicht (18) ist einlagig oder mehrlagig ausgebildet.
b: Bei dem Isoliermittel (20) handelt es sich um eine Folie, die zwischen der Referenzelektrode (24A) oder dem Bestandteil (24B) der Referenzelektrode (24B, 27) und der Elektrodenschicht (12) angeordnet ist.

5. Energiespeicherelement nach Anspruch 1 mit den folgenden zusätzlichen Merkmalen:
a: Die Separatorschicht ist einlagig oder mehrlagig ausgebildet.
b: Bei dem Isoliermittel handelt es sich um eine mikroporöse Beschichtung mit elektrisch isolierenden Eigenschaften auf einer Außenseite der Referenzelektrode oder auf einer Außenseite des Bestandteils der Referenzelektrode.

6. Energiespeicherelement (50) nach einem der vorhergehenden Ansprüche mit dem folgenden zusätzlichen Merkmal:
a. a: Das Metallfilament oder die bahnförmige metallische Beschichtung (24) besteht aus einem mit Lithium legierbaren Metall oder einer mit Lithium legierbaren Metalllegierung aus der Gruppe mit Gold, Silber, Aluminium, Antimon, Zinn und Silizium, das oder die im Betrieb des Energiespeicherelements unter üblichen Betriebsbedingungen (Betriebstemperatur bis 80 °C) Lithium-Ionen reversibel aufnimmt und wieder abgibt.

7. Energiespeicherelement (60) nach einem der Ansprüche 1 bis 5 mit den folgenden zusätzlichen Merkmalen:
a: Die Referenzelektrode (24B, 27) umfasst als ersten Bestandteil (27) eine Elektrode auf Basis einer Verbindung, die Lithiumionen reversibel aufnehmen und wieder abgeben kann.
b: Als zweiten Bestandteil (24B) umfasst die Referenzelektrode (24B, 27) das mindestens eine Metallfilament oder die bahnförmige metallische Beschichtung (24).
c: Das Metallfilament oder die bahnförmige metallische Beschichtung besteht aus einem Metall oder einer Metalllegierung aus der Gruppe mit Titan, Nickel, Edelstahl und Kupfer, das oder die im Betrieb des Energiespeicherelements unter üblichen Betriebsbedingungen (Betriebstemperatur bis 80 °C) weder mit Lithium legiert noch Lithium-Ionen reversibel aufnimmt und abgibt.
d: Ausschließlich der zweite Bestandteil (24B) der Referenzelektrode (24B, 27) ist zwischen der mindestens einen Lage der Separatorschicht (18) und einer der Elektrodenschichten (12) positioniert.
e: Der erste Bestandteil (27) und der zweite Bestandteil (24B) der Referenzelektrode (24B, 27) sind elektrisch miteinander verbunden.

8. Energiespeicherelement (50; 60) nach einem der vorhergehenden Ansprüche mit einem der folgenden zusätzlichen Merkmale:
a: Die zwischen der Separatorschicht (18) und der einen der Elektrodenschichten (12) positionierte Referenzelektrode (24A) oder der dort positionierte Bestandteil (24B) der Referenzelektrode (24B, 27), insbesondere die Sonde (24B), liegt in Form einer Beschichtung (24) vor, die über eine physikalische oder chemische Gasphasenabscheidung gebildet wurde.
b: Die zwischen der Separatorschicht (18) und der einen der Elektrodenschichten (12) positionierte Referenzelektrode (24A) oder der dort positionierte Bestandteil (24B) der Referenzelektrode (24B, 27), insbesondere die Sonde (24B), liegt in Form einer Beschichtung (24) vor, die über ein Druckverfahren gebildet wurde.

9. Energiespeicherelement (50; 60) nach einem der vorhergehenden Ansprüche mit mindestens einem der folgenden zusätzlichen Merkmale:
a: Die bahnförmige metallische Beschichtung (24) ist oder umfasst eine Bahn mit einer Breite im Bereich von 0,1 mm bis 5 mm.
b: Die bahnförmige metallische Beschichtung (24) ist oder umfasst eine Bahn mit einer Dicke im Bereich von 5 nm bis 500 nm.
c: Der Durchmesser des mindestens einen Filaments liegt im Bereich von 10 µm bis 100 µm.
d: Das mindestens eine Metallfilament oder die Bahnen der bahnförmigen metallischen Beschichtung bilden eine Leiterstruktur aus.

10. Energiespeicherelement (50; 60) nach einem der vorhergehenden Ansprüche mit einem der folgenden zusätzlichen Merkmale:
a: das Gehäuse ist ein metallisches Gehäuse mit zwei Poldurchführungen.
b: das Gehäuse (30) ist ein metallisches oder nichtmetallisches Gehäuse mit drei Poldurchführungen.

11. Energiespeicherelement nach einem der vorhergehenden Ansprüche mit dem folgenden zusätzlichen Merkmal:
a: das Energiespeicherelement umfasst eine elektronische Schaltung zur Überwachung seiner Spannung, die mit den Elektrodenschichten und der Referenzelektrode elektrisch verbunden ist.

12. Energiespeicherelement (50; 60) nach einem der vorhergehenden Ansprüche mit den folgenden zusätzlichen Merkmalen:
a: Die Elektrodenschichten (12, 14) und die Separatorschicht (18) liegen in Form von Bändern vor und sind zu einem bandförmigen Schichtverbund zusammengefügt.
b: Der bandförmige Schichtverbund liegt als Wickel (10) vor und umfasst die Elektrodenschichten (12, 14) und die Separatorschicht (18) in einer spiralförmig um eine Wickelachse (4) gewickelten Anordnung.
c: Der Wickel (10) weist zwei Stirnseiten auf, die von Längsrändern der Elektrodenschichten (12, 14) und der Separatorschicht (18) gebildet werden.
d: Das Isoliermittel (20) ist ein Streifen aus einer Folie aus einem mikroporösen Material mit elektrisch isolierenden Eigenschaften, der eine erste Flachseite (22) und eine zweite Flachseite aufweist.
e: Die Referenzelektrode (24A) oder der Bestandteil (24B) der Referenzelektrode (24B, 27) ist eine bahnförmige metallische Beschichtung (24) auf der ersten Flachseite (22) des Folienstreifens (20).
f: Der Folienstreifen (20) ist mitsamt der bahnförmigen metallischen Beschichtung (24) in den Schichtverbund (10) integriert und parallel zu der Wickelachse (4) ausgerichtet, wobei ein Ende des Folienstreifens (20) an einer der Stirnseiten aus dem Wickel (10) herausragt, so dass die bahnförmige metallische Beschichtung (24) frei zugänglich ist.
g: Innerhalb des Schichtverbunds (10) steht die erste Flachseite (22) des Folienstreifens in Kontakt mit der Separatorschicht (18) und die zweite Flachseite in Kontakt mit einer der Elektrodenschichten (12).

13. Energiespeicherelement (50; 60) nach Anspruch 12 mit dem folgenden zusätzlichen Merkmal:
a: Die bahnförmige metallische Beschichtung (24) ist an dem aus der Stirnseite des Wickels (10) herausragenden Ende des Folienstreifens (20) mit einem elektrischen Leiter (46) verbunden.

14. Energiespeicherelement nach einem der vorhergehenden Ansprüche mit den folgenden zusätzlichen Merkmalen:
a: Die Elektrodenschichten und die Separatorschicht liegen in Form von Schichten vor und sind zu einem Schichtverbund zusammengefügt.
b: Der Schichtverbund ist Bestandteil eines Stapels aus mindestens zwei Schichtverbünden.
d: Das Isoliermittel ist ein Streifen aus einer Folie aus einem mikroporösen Material mit elektrisch isolierenden Eigenschaften, der eine erste Flachseite und eine zweite Flachseite aufweist.
e: Die Referenzelektrode oder der Bestandteil der Referenzelektrode ist eine bahnförmige metallische Beschichtung auf der ersten Flachseite des Folienstreifens.
f: Der Folienstreifen ist mitsamt der bahnförmigen metallischen Beschichtung in mindestens einen der den Stapel bildenden Schichtverbünde integriert, wobei ein Ende des Folienstreifens aus dem Stapel herausragt, so dass die bahnförmige metallische Beschichtung frei zugänglich ist.
g: Innerhalb des mindestens einen Schichtverbunds steht die erste Flachseite des Folienstreifens in Kontakt mit der Separatorschicht und die zweite Flachseite in Kontakt mit einer der Elektrodenschichten.

## Claims

1. Secondary energy storage element (50; 60) having the features
a: it comprises a layer composite (10) having an electrode layer (12) comprising a positive electrode material and an electrode layer (14) comprising a negative electrode material and a separator layer (18) arranged therebetween,
b: the separator layer (18) comprises at least one ply composed of a microporous material having electrically insulating properties,
c: it comprises a reference electrode (24A; 24B, 27),
d: it comprises an electrolyte with which the layer composite (10) is impregnated and via which the separator layer (18), the electrode layers (12 and 14) and the reference electrode (24A; 24B, 27) are in contact,
e: it comprises a housing (30) enclosing the layer composite (10), the reference electrode (24A; 24B, 27) and the electrolyte,
f: the housing (30) has three poles, which are electrically insulated from one another and able to be tapped from outside the housing (30), of which the first pole (40) is electrically connected to the electrode layer (12) comprising the positive electrode material, the second pole (42) is electrically connected to the electrode layer (14) comprising the negative electrode material and the third pole (44) is electrically connected to the reference electrode (24A; 24B, 27),
and the additional features
g: within the layer composite, the positive and negative electrode layers enclose between them an overlap region, and
h: the reference electrode (24A) or a constituent part (24B) of the reference electrode (24B, 27) is positioned between the at least one ply of the separator layer (18) and one of the electrode layers (12) and is electrically insulated from said electrode layer (12) by means of an insulating means (20), and
i: the reference electrode (24A) or the constituent part (24B) of the reference electrode (24B, 27) that is positioned there is at least one metal filament or a sheet-type metallic coating (24) disposed within the overlap region on a surface of the at least one ply of the separator layer or a surface (22) of the insulating means (20), and
j: the at least one metal filament or the sheet-type metallic coating covers on said surface an area of a maximum of 5% of the area over which the overlap region extends.

2. Energy storage element according to Claim 1, having the following additional features:
a: the separator layer is configured in multi-ply fashion and comprises a first ply composed of the microporous material having the electrically insulating properties and a second ply composed of the microporous material having the electrically insulating properties,
b: the insulating means is the second ply,
c: the reference electrode or the constituent part of the reference electrode is arranged between the first and second plies.

3. Energy storage element according to Claim 1, having the following additional features:
a: the separator layer is configured with one ply or multiple plies,
b: the insulating means is a coating on an outer side of the separator layer or an outer side of one of the electrode layers, wherein the reference electrode or the constituent part of the reference electrode is arranged between the outer side of the separator layer and the coating.

4. Energy storage element (50; 60) according to Claim 1, having the following additional features:
a: the separator layer (18) is configured with one ply or multiple plies,
b: the insulating means (20) is a film arranged between the reference electrode (24A) or the constituent part (24B) of the reference electrode (24B, 27) and the electrode layer (12).

5. Energy storage element according to Claim 1, having the following additional features:
a: the separator layer is configured with one ply or multiple plies,
b: the insulating means is a microporous coating having electrically insulating properties on an outer side of the reference electrode or on an outer side of the constituent part of the reference electrode.

6. Energy storage element (50) according to any of the preceding claims, having the following additional feature:
a: the metal filament or the sheet-type metallic coating (24) consists of a metal which is able to be alloyed with lithium, or of a metal alloy from the group consisting of gold, silver, aluminium, antimony, tin and silicon, which is able to be alloyed with lithium and reversibly takes up lithium ions and releases them again during operation of the energy storage element under customary operating conditions (operating temperature of up to 80°C).

7. Energy storage element (60) according to any of Claims 1 to 5, having the following additional features:
a: the reference electrode (24B, 27) comprises as first constituent part (27) an electrode on the basis of a compound which can reversibly take up lithium ions and release them again,
b: as second constituent part (24B), the reference electrode (24B, 27) comprises the at least one metal filament or the sheet-type metallic coating (24),
c: the metal filament or the sheet-type metallic coating consists of a metal or a metal alloy from the group consisting of titanium, nickel, stainless steel and copper, which neither alloys with lithium nor reversibly takes up and releases lithium ions during operation of the energy storage element under customary operating conditions (operating temperature of up to 80°C),
d: exclusively the second constituent part (24B) of the reference electrode (24B, 27) is positioned between the at least one ply of the separator layer (18) and one of the electrode layers (12),
e: the first constituent part (27) and the second constituent part (24B) of the reference electrode (24B, 27) are electrically connected to one another.

8. Energy storage element (50; 60) according to any of the preceding claims, having one of the following additional features:
a: the reference electrode (24A) positioned between the separator layer (18) and said one of the electrode layers (12), or the constituent part (24B) of the reference electrode (24B, 27) that is positioned there, in particular the probe (24B), is present in the form of a coating (24) which was formed by means of a physical or chemical vapour deposition,
b: the reference electrode (24A) positioned between the separator layer (18) and said one of the electrode layers (12), or the constituent part (24B) of the reference electrode (24B, 27) that is positioned there, in particular the probe (24B), is present in the form of a coating (24) which was formed by means of a printing method.

9. Energy storage element (50; 60) according to any of the preceding claims, having at least one of the following additional features:
a: the sheet-type metallic coating (24) is or comprises a sheet having a width in the range of 0.1 mm to 5 mm,
b: the sheet-type metallic coating (24) is or comprises a sheet having a thickness in the range of 5 nm to 500 nm,
c: the diameter of the at least one filament lies in the range of 10 µm to 100 µm,
d: the at least one metal filament or the sheets of the sheet-type metallic coating form(s) a conductor structure.

10. Energy storage element (50; 60) according to any of the preceding claims, having one of the following additional features:
a: the housing is a metallic housing having two pole bushings,
b: the housing (30) is a metallic or non-metallic housing having three pole bushings.

11. Energy storage element according to any of the preceding claims, having the following additional feature:
a: the energy storage element comprises an electronic circuit for monitoring its voltage, which is electrically connected to the electrode layers and the reference electrode.

12. Energy storage element (50; 60) according to any of the preceding claims, having the following additional features:
a: the electrode layers (12, 14) and the separator layer (18) are present in the form of tapes and are joined together to form a tape-type layer composite,
b: the tape-type layer composite is present as a winding (10) and comprises the electrode layers (12, 14) and the separator layer (18) in an arrangement wound spirally around a winding axis (4),
c: the winding (10) has two end sides formed by longitudinal edges of the electrode layers (12, 14) and the separator layer (18),
d: the insulating means (20) is a strip composed of a film composed of a microporous material having electrically insulating properties, which strip has a first flat side (22) and a second flat side,
e: the reference electrode (24A) or the constituent part (24B) of the reference electrode (24B, 27) is a sheet-type metallic coating (24) on the first flat side (22) of the film strip (20),
f: the film strip (20) is integrated together with the sheet-type metallic coating (24) into the layer composite (10) and is aligned parallel to the winding axis (4), wherein one end of the film strip (20) projects from the winding (10) at one of the end sides, such that the sheet-type metallic coating (24) is freely accessible,
g: within the layer composite (10), the first flat side (22) of the film strip is in contact with the separator layer (18) and the second flat side is in contact with one of the electrode layers (12).

13. Energy storage element (50; 60) according to Claim 12, having the following additional feature:
a: the sheet-type metallic coating (24) is connected to an electrical conductor (46) at that end of the film strip (20) which projects from the end side of the winding (10) .

14. Energy storage element according to any of the preceding claims, having the following additional features:
a: the electrode layers and the separator layer are present in the form of layers and are joined together to form a layer composite,
b: the layer composite is a constituent part of a stack of at least two layer composites,
d: the insulating means is a strip composed of a film composed of a microporous material having electrically insulating properties, which strip has a first flat side and a second flat side,
e: the reference electrode or the constituent part of the reference electrode is a sheet-type metallic coating on the first flat side of the film strip,
f: the film strip is integrated together with the sheet-type metallic coating into at least one of the layer composites forming the stack, wherein one end of the film strip projects from the stack, such that the sheet-type metallic coating is freely accessible,
g: within the at least one layer composite, the first flat side of the film strip is in contact with the separator layer and the second flat side is in contact with one of the electrode layers.

## Revendications

1. Élément de stockage d'énergie secondaire (50 ; 60) ayant les caractéristiques suivantes
a : il comprend un composite stratifié (10) pourvu d'une couche d'électrode (12) comprenant une matière d'électrode positive et d'une couche d'électrode (14) comprenant une matière d'électrode négative et d'une couche de séparation (18) disposée entre celles-ci,
b : la couche de séparation (18) comprend au moins une strate de matière microporeuse ayant des propriétés électriquement isolantes,
c : il comprend une électrode de référence (24A ; 24B, 27),
d : il comprend un électrolyte dont le composite stratifié (10) est imprégné et par lequel la couche de séparation (18), les couches d'électrodes (12 et 14) et l'électrode de référence (24A ; 24B, 27) sont en contact,
e : il comprend un boîtier (30) qui renferme le composite stratifié (10), l'électrode de référence (24A ; 24B, 27) et l'électrolyte,
f : le boîtier (30) comporte trois pôles qui sont isolés électriquement les uns des autres et qui peuvent être prélevés depuis l'extérieur du boîtier (30), le premier pôle (40) étant relié à la couche d'électrode (12) pourvue de la matière l'électrode positive, le deuxième pôle (42) étant relié à la couche d'électrode (14) pourvue de la matière d'électrode négative et le troisième pôle (44) étant relié électriquement à l'électrode de référence (24A ; 24B, 27),
et les caractéristiques supplémentaires suivantes
g : dans le composite stratifié, les couches d'électrode positive et négative renferment entre elles une zone de chevauchement, et
h : l'électrode de référence (24A) ou une partie constitutive (24B) de l'électrode de référence (24B, 27) est positionnée entre l'au moins une strate de la couche de séparation (18) et une des couches d'électrode (12) et est isolée électriquement de cette couche d'électrode (12) à l'aide d'un moyen isolant (20), et
i : l'électrode de référence (24A) ou la partie constitutive (24B) de l'électrode de référence (24B, 27), qui y est positionnée, est au moins un filament métallique ou un revêtement métallique (24) en forme de bande qui est disposée à l'intérieur de la zone de chevauchement sur une surface de l'au moins une strate de la couche de séparation ou une surface (22) du moyen isolant (20), et
j : l'au moins un filament métallique ou le revêtement métallique en forme de bande couvre sur cette surface une aire au maximum de 5 % de l'aire sur laquelle s'étend la zone de chevauchement.

2. Élément de stockage d'énergie selon la revendication 1 ayant les caractéristiques supplémentaires suivantes :
a : la couche de séparation est multi-strates et comprend une première state de la matière microporeuse ayant les propriétés électriquement isolantes et une deuxième strate de la matière microporeuse ayant les propriétés électriquement isolantes,
b : le moyen isolant est la deuxième strate,
c : l'électrode de référence ou la partie constitutive de l'électrode de référence est disposée entre la première et la deuxième strate.

3. Élément de stockage d'énergie selon la revendication 1 ou 2 ayant les caractéristiques supplémentaires suivantes :
a : la couche de séparation est de conception mono-strate ou multi-strates,
b : le moyen isolant est un revêtement situé sur un côté extérieur de la couche de séparation ou un côté extérieur d'une des couches d'électrodes, l'électrode de référence ou la partie constitutive de l'électrode de référence étant disposée entre le côté extérieur de la couche de séparation et le revêtement.

4. Élément de stockage d'énergie (50 ; 60) selon la revendication 1 ayant les caractéristiques supplémentaires suivantes :
a : la couche de séparation (18) est de conception mono-strate ou multi-strates,
b : le moyen isolant (20) est un film qui est disposé entre l'électrode de référence (24A) ou la partie constitutive (24B) de l'électrode de référence (24B, 27) et la couche d'électrode (12).

5. Élément de stockage d'énergie selon la revendication 1 ayant les caractéristiques supplémentaires suivantes :
a : la couche de séparation est de conception mono-strate ou multi-strates,
b : le moyen isolant est un revêtement microporeux ayant les propriétés électriquement isolantes sur un côté extérieur de l'électrode de référence ou sur un côté extérieur de la partie constitutive de l'électrode de référence.

6. Élément de stockage d'énergie (50) selon l'une des revendications précédentes ayant la caractéristique supplémentaire suivante :
a : le filament métallique ou le revêtement métallique (24) en forme de bande est en un métal pouvant être allié au lithium, ou en un alliage métallique pouvant être allié au lithium, qui appartient au groupe comprenant l'or, l'argent, l'aluminium, l'antimoine, l'étain et le silicium et qui absorbe et libère à nouveau de manière réversible des ions lithium pendant le fonctionnement de l'élément de stockage d'énergie dans les conditions de fonctionnement (température de fonctionnement jusqu'à 80 °C).

7. Élément de stockage d'énergie (60) selon l'une des revendications 1 à 5 ayant les caractéristiques supplémentaires suivantes :
a : l'électrode de référence (24B, 27) comprend comme première partie constitutive (27) une électrode à base d'un composé qui peut absorber et à nouveau libérer de manière réversible les ions lithium,
b : l'électrode de référence (24B, 27) comprend comme deuxième partie constitutive (24B) l'au moins un filament métallique ou le revêtement métallique (24) en forme de bande,
c : le filament métallique ou le revêtement métallique en forme de bande est en un métal ou un alliage métallique qui appartient au groupe comprenant le titane, le nickel, l'acier fin et le cuivre et qui ne s'allie pas au lithium et n'absorbe et ne libère pas non plus d'ions lithium de manière réversible pendant le fonctionnement de l'élément de stockage d'énergie dans les conditions de fonctionnement habituelles (température de fonctionnement jusqu'à 80 °C),
d : seule la deuxième partie constitutive (24B) de l'électrode de référence (24B, 27) est positionnée entre l'au moins une strate de la couche de séparation (18) et l'une des couches d'électrode (12),
e : la première partie constitutive (27) et la deuxième partie constitutive (24B) de l'électrode de référence (24B, 27) sont reliées électriquement l'une à l'autre.

8. Élément de stockage d'énergie (50 ; 60) selon l'une des revendications précédentes ayant l'une des caractéristiques supplémentaires suivantes :
a : l'électrode de référence (24A) positionnée entre la couche de séparation (18) et l'une des couches d'électrode (12) ou la partie constitutive (24B) de l'électrode de référence (24B, 27), qui y est positionnée, notamment la sonde (24B), se présente sous la forme d'un revêtement (24) qui a été formé par dépôt physique ou chimique en phase vapeur,
b : l'électrode de référence (24A) positionnée entre la couche de séparation (18) et l'une des couches d'électrode (12) ou la partie constitutive (24B) de l'électrode de référence (24B, 27), qui y est positionnée, notamment la sonde (24B), se présente sous la forme d'un revêtement (24) qui a été formé par un procédé d'impression.

9. Élément de stockage d'énergie (50 ; 60) selon l'une des revendications précédentes ayant l'une au moins des caractéristiques supplémentaires suivantes :
a : le revêtement métallique (24) en forme de bande est ou comprend une bande d'une largeur dans la plage allant de 0,1 mm à 5 mm,
b : le revêtement métallique (24) en forme de bande est ou comprend une bande d'une épaisseur dans la plage allant de 5 nm à 500 nm,
c : le diamètre de l'au moins un filament est dans la plage allant de 10 µm à 100 µm,
d : l'au moins un filament métallique ou les bandes du revêtement métallique en forme de bande forment une structure de conducteurs.

10. Élément de stockage d'énergie (50 ; 60) selon l'une des revendications précédentes ayant l'une des caractéristiques supplémentaires suivantes :
a : le boîtier est un boîtier métallique pourvu de deux passages de pôle,
b : le boîtier (30) est un boîtier métallique ou non métallique pourvu de trois passages de pôle.

11. Élément de stockage d'énergie selon l'une des revendications précédentes ayant la caractéristique supplémentaire suivante :
a : l'élément de stockage d'énergie comprend un circuit électronique qui est destiné à surveiller la tension de celui-ci et qui est relié électriquement aux couches d'électrode et à l'électrode de référence.

12. Élément de stockage d'énergie (50 ; 60) selon l'une des revendications précédentes ayant les caractéristiques supplémentaires suivantes :
a : les couches d'électrode (12, 14) et la couche de séparation (18) se présentent sous la forme de bandes et sont assemblées pour former un composite stratifié en forme de bande,
b : le composite stratifié en forme de bande se présente sous la forme d'une bobine (10) et comprend les couches d'électrode (12, 14) et la couche de séparation (18) dans un agencement enroulé en spirale autour d'un axe de bobine (4),
c : l'enroulement (10) comporte deux côtés frontaux qui sont formées par des bords longitudinaux des couches d'électrode (12, 14) et de la couche de séparation (18),
d : le moyen isolant (20) est une bande d'un film en matière microporeuse ayant des propriétés électriquement isolantes, lequel comporte un premier côté plat (22) et un deuxième côté plat,
e : l'électrode de référence (24A) ou la partie constitutive (24B) de l'électrode de référence (24B, 27) est un revêtement métallique (24) en forme de bande sur le premier côté plat (22) de la bande de film (20),
f : la bande de film (20) est intégrée dans le composite stratifié (10) avec le revêtement métallique (24) en forme de bande et est orientée parallèlement à l'axe d'enroulement (4), une extrémité de la bande de film (20) faisant saillie de la bobine (10) sur l'un des côtés frontaux de sorte que le revêtement métallique (24) en forme de bande soit librement accessible,
g : à l'intérieur du composite stratifié (10), le premier côté plat (22) de la bande de film est en contact avec la couche de séparation (18) et le deuxième côté plat est en contact avec l'une des couches d'électrode (12).

13. Élément de stockage d'énergie (50 ; 60) selon la revendication 12 ayant la caractéristique supplémentaire suivante :
a : le revêtement métallique (24) en forme de bande est relié à un conducteur électrique (46) à l'extrémité de la bande de film (20) qui fait saillie du côté frontal de la bobine (10).

14. Élément de stockage d'énergie selon l'une des revendications précédentes ayant les caractéristiques supplémentaires suivantes :
a : les couches d'électrode et la couche de séparation se présentent sous la forme de couches et sont assemblées pour former un composite stratifié,
b : le composite stratifié fait partie d'un empilement d'au moins deux composites stratifiés,
d : le moyen isolant est une bande d'un film de matière microporeuse qui a des propriétés électriquement isolantes et qui comporte un premier côté plat et un deuxième côté plat,
e : l'électrode de référence ou la partie constitutive de l'électrode de référence est un revêtement métallique en forme de bande sur le premier côté plat de la bande de film,
f : la bande de film est intégrée avec le revêtement métallique en forme de bande dans l'un au moins des composites stratifiés formant l'empilement, une extrémité de la bande de film faisant saillie de l'empilement de sorte que le revêtement métallique en forme de bande soit librement accessible,
g : à l'intérieur de l'au moins un composite stratifié, le premier côté plat de la bande de film est en contact avec la couche de séparation et le deuxième côté plat est en contact avec l'une des couches d'électrode.
